Europäisches Patentamt

European Patent Office

Office européen des brevets

(11) Publication number: **0 156 156**
**A1**

(12) # EUROPEAN PATENT APPLICATION

(21) Application number: **85101755.8**

(22) Date of filing: **01.12.81**

(51) Int. Cl.⁴: **H 01 L 31/10**

(30) Priority: **02.12.80 JP 169889/80**

(43) Date of publication of application:
**02.10.85 Bulletin 85/40**

(84) Designated Contracting States:
**DE FR GB NL**

(60) Publication number of the earlier application
in accordance with Art. 76 EPC: **0 053 513**

(71) Applicant: **FUJITSU LIMITED**
**1015, Kamikodanaka Nakahara-ku**
**Kawasaki-shi Kanagawa 211(JP)**

(72) Inventor: **Osaka, Fukunobu c/o FUJITSU LIMITED**
**Patent Department 1015 Kamikodanaka Nakahara-ku**
**Kawasaki-shi Kanagawa 211(JP)**

(72) Inventor: **Shirai, Tatsunori c/o FUJITSU LIMITED**
**Patent Department 1015 Kamikodanaka Nakahara-ku**
**Kawasaki-shi Kanagawa 211(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **Avalanche photodiodes.**

(57) An APD has a light absorbing layer (3) and an active layer (5). A surface layer (16) is formed on the active layer (5). A well shaped p-n junction is formed in the surface layer (16) and the active layer (5) the bottom of the well shaped p-n junction being in the active layer (5).

Fig.1

EP 0 156 156 A1

-1-

# AVALANCHE PHOTODIODES

The present invention relates to avalanche photodiodes (hereinafter referred to as APD's).

An APD is a type of photodiode which can offer various performance advantages, such as higher grade avalanche gain, sensitivity and response time and lower values of dark-current and noise, as compared with other types. These advantages arise from an avalanche breakdown phenomenon which occurs at a p-n junction which is arranged in a multiplication layer in the APD which has a reverse bias applied thereto when the APD is in use to cause the avalanche multiplication of a current of electrons and/or holes generated in a light absorbing region of the device which is exposed to receive light arriving at that region.

For such advantages to be realised, it must be provided that avalanche breakdown occurs exclusively and uniformly in a central region of the diode where light is absorbed. Therefore, APD's require some means effective to limit breakdown to a central region of the above mentioned p-n junction.

The wavelength of light to which an APD is sensitive is determined by the band gap $E_g$ of the material of which the light absorbing layer of the APD is made. In order to produce an APD sensitive to longer wavelength light, a combination of layers of semiconductor, one of which has a relatively small band gap $E_g$ and functions as a light absorbing layer and the other of which has a relatively large band gap $E_g$ and functions as a multiplication layer, is convenient. For the production of an APD sensitive to light in the wavelength range 1.2 to 1.65 micrometers, a combination of $In_xGa_{1-x}As_{1-y}P_y$ and $InP$, or a combination of $GaSb$ and

-2-

$Ga_xAl_{1-x}Sb$ is preferably employed.

Multilayered APD's employing the above mentioned group III-V compound or alloy semiconductors have been proposed which have a so-called self guard ring layer configuration, in which a p-n junction is formed for the purpose of avalanche multiplication slightly above the heterojunction between the light absorbing layer, of $In_xGa_{1-x}As$, $In_xGa_{1-x}As_{1-y}P_y$ or the like, and the multiplicationlayer, of InP or the like, whereby the intensity of electric field in the light absorbing layer is larger in the central region of the diode, or in a light absorbing region, than in other regions thereof, or in regions not exposed to light, causing the breakdown voltage of the p-n junction to become less in the central region of the diode which is exposed to light than in regions which are not exposed to light. This provides the guard ring effect. The function of this so-called self guard ring configuration is based upon the characteristic that the band gap Eg of the group III-V compound or alloy semiconductor of which the light absorbing layer is made is less than the band gap Eg of the group III-V compound or alloy semiconductor of which the multiplication or active layer is made and that the breakdown voltage is less for the former than for the latter. It has been determined that this so-called self guard ring configuration provides an excellent guard ring effect.

Electronics Letters, Vol. 16, No. 18, August 1980, pages 716 to 717, discloses an InP/InGaAsP avalanche photodiode with a guard ring structure. To form the photodiode a lattice matched n-InGaAsP layer is grown on a $n^+$-InP substrate, with two n-InP layers grown on the n-InGaAsP layer, by liquid phase epitaxy. The donor concentration of the upper n-InP layer is designed to be higher than those of the lower n-InP and n-InGaAsP layers. The upper n-InP layer is etched off except for an active region, then a $p^+$-InP layer is formed on the active region and the lower n-InP layer. A guard ring effect is provided because the active region p-n junction is formed with the more heavily doped upper n-InP layer (the active region).

The inventors of the present invention have, however, discovered that APD's having the so-called self guard ring configuration have a drawback as described below.

Since the intensity of electric field is necessarily high in the light absorbing layer, a tunnel current or a

-4-

current component resulting from carriers directly excited by the high intensity of electric field has inevitably occur red in the light absorbing layer, giving rise to various adverse effects, e.g. relatively large amounts of dark current, noise or the like. It is well-known that the magnitude of tunnel effect is larger for a substance having a lesser band gap Eg, such as group III-V compound or alloy semiconductors, e.g. $In_xGa_{1-x}As_{1-y}P_y$ or GaSb and the like.

Now, it is well-known that the fundamental absorption edge ( is determined by the equality )$\lambda$= hc/Eg, and in view of the fact that the signal transmission loss in an optical fibre is less for longer wavelength light it is therefore preferable to use APD's sensitive to longer wavelength light, having thus a light absorbing layer made of a material having a lesser band gap Eg, in fibre optics communications.

For this reason, the above described drawback arising from the relatively large amount of tunnel current which is inherent in APD's having the so-called self guard ring configuration is of serious practical significance.

The present invention is concerned with the provision of APD's which do not suffer from the above-mentioned drawback. Embodiments of the present invention can also afford various other advantages.

The present invention provides a multilayer APD having a guard ring configuration which can readily realise an efficient guard ring effect without suffering the above-described tunnel current problem, as a result providing for the realisation of higher grades of avalanche-gain, sensitivity and response time and lower values of dark-current and noise.

The present invention provides for an APD of a planar type.

For example, the present invention can provide an APD sensitive to light in a wavelength range 1.2 to 1.65 micrometers, which is provided with a light absorbing layer made of a group III-V compound or alloy semiconductor, for example $In_xGa_{1-x}As_{1-y}P_y$ or GaSb, and with a multiplication or active layer made of another group III-V alloy or compound/semiconductor, for example InP or $Ga_xAl_{1-x}Sb$, having a larger band gap Eg than that of the material of the light absorbing layer.

This invention can further provide a planar type APD having a more efficient guard ring effect, realising a more pronounced difference in breakdown voltage between the central region of the p-n junction and other regions thereof.

This invention can also provide a planar type APD having a simple layer configuration, in which the number of essential design parameters is reduced from three to two, thereby allowing considerable freedom for design and production of the APD.

The present invention has an embodiment which is an APD having:-

(a)   a light absorbing layer made of a group III-V compound or alloy semiconductor, such as $In_xGa_{1-x}As_yP_{1-y}$, GaSb, or the like, containing one or some impurities of one conductivity type preferably in a relatively low concentration,

(b)   an active layer of a relatively large thickness, e.g. 2 to 3 micrometers, made of a material which allows lattice matching between itself and the light absorbing layer and which has a larger band gap Eg than that of the semiconductor forming the light absorbing layer, preferably a group III-V compound or alloy semiconductor, such as InP in a case in which the light absorbing layer is of $In_xGa_{1-x}As_yP_{1-y}$, or $Ga_xAl_{1-x}Sb$ in a case in which the light absorbing layer is of GaSb, primarily containing one or some impurities of a conductivity type identical to that of the light absorbing layer in a concentration the same as or greater than that of the light absorbing layer, the active layer being grown on the light absorbing layer and,

(c)   a surface layer made of a material which allows lattice matching between itself and the active layer and has a larger band gap Eg than that of the semiconductor forming the light absorbing layer, preferably a group III-V compound or alloy semiconductor substantially identical to that of the active layer, primarily containing one or some impurities of a conductivity type the same as that of the light absorbing layer in a concentration which is less than, for example several tenths of, that of the active layer, or less, e.g. $1 \times 10^{15}/cm^3$, the surface layer and an upper portion of the active layer having formed therein a region constituting a light sensitive region which contains one or some impurities of a conductivity type different from that of the impurities of the active and light absorbing layers in a high concentration, e.g. approximately $10^{18}/cm^3$, and the light sensitive region being separated from the other regions of the active layer and the surface layer by a p-n junction which extends down through the surface layer and into the active layer. The p-n junction may have a horizontal part in the active layer surrounded by parts which rapidly rise through the surface layer. The sides of the p-n junction may rise substantially vertically through the surface layer.

Such an APD has the following attributes.

For the production of APD's in accordance with the first and second embodiments of the invention of European Patent Application No. 81305658.7 publication No. 0 053 153 of which the present European Application is a divisional application, precise regulation is required of three independent parameters - (a) carrier concentration in an active layer, (b) carrier concentration in a middle layer, and (c) the distance between a p-n junction and the interface between the active layer and the middle layer. Further attention must be paid to the curvature of the p-n junction in order to prevent a high intensity electric field occurring at curved portions of the p-n junction. In an APD in accordance with the present invention, the parameters which must be regulated are reduced to two and the layer configuration is simplified thereby allowing a considerable latitude for design and production.

It will be understood that the layer thicknesses above are indicated only by way of example. Devices embodying the present invention may be constructed with layer thicknesses different from those mentioned

-8-

above, as will be seen from the description below in which reference is made to the drawings. Values of impurity concentration mentioned above are likewise by way of example only.

Reference is made, by way of example, to the accompanying drawings, in which:-

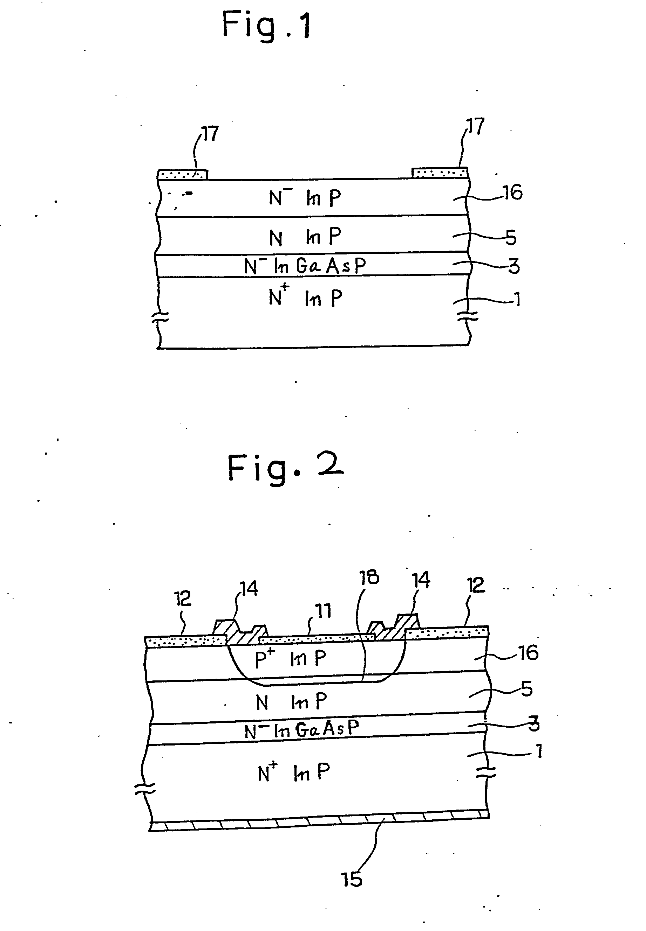

Figures 1 and 2 are respective sectional views for assistance in explanation of the structure of an APD in accordance with an embodiment ——————————————————— of the present invention, Figure 1 showing the APD at an intermediate stage in its manufacture, and Figure 2 showing the finished APD.

For simplicity, the description given herebelow of an APD in accordance with an embodiment of this invention will be provided in relation to an APD having an n-InP substrate, an $n-In_xGa_{1-x}As_yP_{1-y}$ light absorbing layer, and an n-InP active layer. Production of the layers of the APD will be assumed to be effected by continuously growing the layers employing liquid phase epitaxy in one process. Of course, lattice matching is required between adjacent layers.

The APD of Figs. 1 and 2 offers the required reduction in dark current and excess noise e.g. tunnel current and can provide the required pronounced difference in breakdown voltages. In addition, the APD has a simpler layer configuration which can be produced by a simpler method which is subject to a lesser number of parameters requiring critical regulation, as compared with APD's as described in European Patent Application No. 81305658.7, publication N . ( 0?? 153, of which this is a divisional application.

With reference to Figure 1, liquid phase epitaxy is employed to grow an InP surface layer 16 having a thickness of approximately 4 to 5 micrometers and containing one or more n-type impurities to a concentration of approximately $1 \times 10^{15}/cm^3$ on an InP active layer 5 having a thickness of approximately 4 to 5 micrometers and containing one or more n-type impurities in a concentration of approximately $5 \times 10^{15}/cm^3$ on an $In_xGa_{1-x}As_yP_{1-y}$ light absorbing layer 3 having a thickness of approximately 2 micrometers and containing one or more n-type impurities in a concentration of approximately $5 \times 10^{15}/cm^3$ on an InP substrate 1 containing one or more n-type impurities in a concentration of approximately $10^{18}/cm^3$.

Over a period in which the InP surface layer 16 is grown, primarily based on the unintentional doping basis, one or more p-type impurities are supplied to compensate the n-type impurities inherently contained in the source.

A chemical vapour deposition process is employed for producing a thin $SiO_2$ layer 17 on the InP surface layer 16, before a photolithography process is employed to remove the layer 17 from an area corresponding to a light window for the purpose of producing a diffusion mask.

With reference to Figure 2, one or more p-type impurities are diffused into the wafer in a concentration of approximately $10^{18}/cm^3$ employing the layer 17 as a mask to produce a p-n junction 18 in a neighbourhood of the interface between the n-InP surface layer 16 and the n-InP active layer 5, or at a deeper level.

After the layer 17 is removed, another $SiO_2$ film 11 is produced on the light window to act as an anti-reflection coating, and a third $SiO_2$ film

12 is produced on the guard ring region and on the region surrounding the guard ring region. Such films 11 and 12 are separated from one another to leave an area therebetween on which an anode can be produced.

Thereafter an anode 14 is produced on the surface layer 16 around the light window or the anti-reflection coating 11, within the film 12, and the cathode 15 is produced on the rear surface of the wafer.

The major difference between the layer configuration of the APD illustrated in Figure 7 and APD's in accordance with the invention of European Patent Application No. 81305658.7 is that no middle layer is provided and the location of the p-n junction is somewhere more freely determinable, with the result that the parameters needing careful control in production are virtually limited to the control of the concentration of the active layer, albeit that the location of the p-n junction is of considerable physical significance.

In the APD of Figure 2 the bottom of the p-n junction, which is horizontal, is located in the active layer 5. From its bottom in the active layer 5 the p-n junction rises through the interface between the active layer 5 and the surface layer 16 and through the surface layer 16. Thus, the p-n junction may be said to be well-shaped. The sides of the p-n junction rising from its bottom may rise abruptly or substantially vertically through the surface layer 16.

An APD as illustrated in Fig. 2 can offer a simple layer configuration as illustrated.

By the disposition of different parts of the p-n junction and by the layer configuration provided in accordance with the present invention tunnel current is reduced in the APD embodying the present invention as compared with previous APD's.

0156156

This invention provides an avalanche photodiode with a light absorbing layer, an active layer and a surface layer, grown in this order, having a well shaped p-n junction which penetrates the interface between the surface layer and the active layer to spread along that interface in the active layer. Since impurity concentration in the surface layer is extremely marginal a guard ring effect can be achieved without a large amount of tunnel current flowing through the light absorbing layer in response to the intensity of the electric field.

Claims:

1.    An avalanche photodiode comprising:-

a light absorbing layer (3), of a semiconductor containing at least one impurity of one conductivity type,

an active layer (5) of a semiconductor providing lattice matching between itself and the light absorbing layer (3) and having a larger band gap than that of the semiconductor of the light absorbing layer (3), the active layer (5) being formed on the light absorbing layer (3) and primarily containing at least one impurity of the said one conductivity type, and·

a surface layer (16) of a semiconductor providing lattice matching between itself and the active layer (5) and having a larger band gap than that of the semiconductor of the light absorbing layer (3), the surface layer (16) being formed on the active layer (5) and primarily containing at least one impurity of the said one conductivity type, in a concentration less than that of the active layer (5), but the surface layer (16) and an upper portion of the active layer (5) having therein a region which contains at least one impurity of a conductivity type opposite to the said one conductivity type to provide a light sensitive region separated from other regions of the surface layer and the active layer by a well shaped p-n junction (18) of which the bottom is located in the active layer (5).

2.    An avalanche photodiode as claimed in claim 1, being a planar avalanche photodiode.

3.    An avalanche photodiode as claimed in claim 1 or 2, sensitive to light in the wavelength range 1.2 micrometers to 1.65 micrometers.

-13-

4. An avalanche photodiode as claimed in claim 1, 2 or 3, wherein the light absorbing layer (3) and the active layer (5) are of respective group III-V compound or alloy semiconductors.

5. An avalanche photodiode as claimed in claim 4, wherein the light absorbing layer (3) is of $In_xGa_{1-x}As_yP_{1-y}$ and the active layer (5) is of InP.

6. An avalanche photodiode as claimed in claim 4, wherein the light absorbing layer (3) is of GaSb and the active layer (5) is of $Ga_xAl_{1-x}Sb$.

7. An avalanche photodiode as claimed in any preceding claim, having layers continuously grown using liquid phase epitaxy.

1/1

# Fig.1

$N^-$ In P — 16

N In P — 5

$N^-$ In Ga As P — 3

$N^+$ In P — 1

17    17

# Fig. 2

12    14    11    18    14    12

$P^+$ In P — 16

N In P — 5

$N^-$ In Ga As P — 3

$N^+$ In P — 1

15

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| Y | ELECTRONICS LETTERS, vol. 16, no. 18, 28th August 1980, pages 716-717, Hitchin Herts, GB; F.OSAKA et al.: "InP/InGaAsP avalanche photodiodes with new guard ring structure" * The whole document * | 1,3,4, 5,7 | H 01 L 31/10 |
| Y | APPLIED PHYSICS LETTERS, vol. 35, no. 3, August 1979, pages 251-253, American Institute of Physics, New York, US; KATSUHIKO NISHIDA et al.: "InGaAsP heterostructure avalanche photodiodes with high avalanche gain" * The whole document * | 1-5,7 | |
| A | IDEM. | 6 | TECHNICAL FIELDS SEARCHED (Int. Cl 4) |
| Y | ELECTRONICS LETTERS, vol. 15, no. 15, July 1979, pages 453-455, Hitchin Herts, GB; K.TAGUCHI et al.: "InP-InGaAsP planar avalanche photodiodes with self-guard-ring effect" * The whole document * | 1-5,7 | H 01 L |
| | --- -/- | | |

The present search report has been drawn up for all claims

| Place of search THE HAGUE | Date of completion of the search 18-06-1985 | Examiner VISENTIN A. |
|---|---|---|

# EUROPEAN SEARCH REPORT

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENTS ABSTRACTS OF JAPAN, vol. 4, no. 189 (E-39)[671], 25th December 1980; & JP - A - 55 132 079 (NIPPON DENKI K.K.) 14-10-1980 * The whole document * | 1,2,4,5 | |
| A | IEEE JOURNAL OF QUANTUM ELECTRONICS, vol. QE-15, no. 7, July 1979, pages 549-558, New York, US; H.D.LAW et al.: "III-V alloy heterostructure high speed avalanche photodiodes" | | |
| P,X | ELECTRONICS LETTERS, vol. 17, no. 22, October 1981, pages 826-827, London, GB; T.SHIRAI et al.: "1.3 mum InP/InGaAsP planar avalanche photodiodes" * The whole document * | 1-5,7 | |
| | | | **TECHNICAL FIELDS SEARCHED (Int. Cl. 4)** |

The present search report has been drawn up for all claims

| Place of search | Date of completion of the search | Examiner |
|---|---|---|
| THE HAGUE | 15-06-1985 | VISENTIN A. |